Europäisches Patentamt

European Patent Office

Office européen des brevets

(11) Veröffentlichungsnummer: **0 236 711 B1**

## EUROPÄISCHE PATENTSCHRIFT

(45) Veröffentlichungstag der Patentschrift: **29.05.91**   (51) Int. Cl.⁵: **H05K 7/14**

(21) Anmeldenummer: **87101056.7**

(22) Anmeldetag: **26.01.87**

(54) Automatisierungsgerät.

(30) Priorität: **06.02.86 DE 3603750**
**03.10.86 DE 3633785**

(43) Veröffentlichungstag der Anmeldung:
**16.09.87 Patentblatt 87/38**

(45) Bekanntmachung des Hinweises auf die
Patenterteilung:
**29.05.91 Patentblatt 91/22**

(84) Benannte Vertragsstaaten:
**AT CH DE ES FR GB IT LI SE**

(56) Entgegenhaltungen:
**EP-A- 0 165 434      CH-A- 580 342**
**DE-A- 1 815 041      FR-A- 2 405 565**
**US-A- 4 401 351      US-A- 4 503 484**
**US-A- 4 558 914**

(73) Patentinhaber: **Siemens Aktiengesellschaft**
**Wittelsbacherplatz 2**
**W-8000 München 2(DE)**

(72) Erfinder: **Schmidt, Heinz Dipl.-Ing.**
**Drosselgasse 5**
**W-8451 Kümmersbruck(DE)**
Erfinder: **Meusel, Otto**
**Aufsessstrasse 18**
**W-8520 Erlangen(DE)**
Erfinder: **Schirbl, Reinhard**
**Kreuzfelderstrasse 2**
**W-8460 Schwandorf(DE)**

## Beschreibung

Die Erfindung bezieht sich auf ein Automatisierungsgerät, bestehend aus auf eine Tragschiene aufschnappbaren Baugruppenträgern, die über Steuerleitungen miteinander verbindbar sind, sowie Anschlußmitteln für externe Verdrahtung zu den Baugruppen.

Bei einem bekannten Automatisierungsgerät der obengenannten Art (Siemens-Liste ST 51 1984, Seite 8 und 9) sind generell zehn Baugruppensteckplätze über eine Bus-Leitung miteinander verbunden und auf die Normtragschiene aufgeschnappt. Werden hier lediglich zwei Ein- bzw. Ausgabebaugruppen benötigt, so stehen die restlichen Baugruppensteckplätze leer und unbenutzt.

Aus DE-A-1815041 ist ferner ein Schaltungsmodul für elektrische Installations-Verteilerschränke bekannt. Der Schaltungsmodul in Form einer gedruckten Schaltung ist zwischen die beiden Ränder in eine Tragschiene eingelassen. Zur Kennung und/oder Fixierung von stuer und/oder Installationsgeräten können auf die Tragschiene Montagesokkel aufgeschappt werden. Der Sockel kann neben den Anschlußeinrichtungen der gedruckten Schaltung mit eigenen elektrischen Anschlußeinrichtungen versehen sein.

Der vorliegenden Erfindung liegt die Aufgabe zugrunde, ein Automatisierungsgerät der obengenannten Art dahingehend zu verbessern, daß bei einfachem und sicherem Aufbau das Automatisierungsgerät auch mit einer geringen Anzahl von Einund Ausgabebaugruppen bestückt werden kann, ohne hierbei einen erheblichen Aufwand treiben zu müssen. Dies wird auf einfache Weise dadurch erreicht, daß die Baugruppenträger einzeln als modulare, eine entsprechende Anpassungsschaltung aufweisende Baugruppenträger ausgebildet sind, die über Steckverbindung mit benachbarten Baugruppenträgern elektrisch verbindbar sind. Die hier verwendete Anpaßschaltung ist als serielles Ring-Schieberegister ausgebildet und zwischen Peripheriebaugruppe und Bus als Schnittstelleneinheit zwischengeschaltet. Diese Anpaßschaltung läßt eine parallele Übergabe der einzelnen Binärinformationen zu. Ein gesonderter Abschluß des Bus-Systems ist bei dieser Anpaßschaltung ebenfalls nicht erforderlich. Es werden lediglich soviel Baugruppenträger über Steckverbindung miteinander verbunden, wie Ein- und Ausgabebaugruppen notwendig sind. Um auch bei Bewegungen der einzelnen Baugruppen untereinander eine sichere Verbindung der Baugruppen untereinander zu gewährleisten ist es vorteilhaft, wenn der Baugruppenträger jeweils einen Stecker und eine Buchse aufweist, wobei der Stecker starr und die Buchse über eine flexible Leitung mit der in dem Baugruppenträger gehaltenen Anpaßschaltung verbunden ist. Hierdurch ist eine Bewegung der einzelnen Baugruppen gegeneinander zulässig, ohne die Steckverbindung nachteilig zu beeinflussen. Um Beschädigungen der an der flexiblen Leitung angeschlossenen Buchse zu vermeiden ist es weiterhin von Vorteil, wenn die Buchse in einer Tasche des Baugruppenträgers vor der Verbindung gehalten ist. Eine sogenannte stehende Verdrahtung, d.h. ein Abnehmen bzw. Auswechseln des Baugruppenträgers, ohne die externe Verdrahtung lösen zu müssen, ist möglich, wenn dem Baugruppenträger ein gesonderter Anschlußblock für die externe Verdrahtung zugeordnet ist, der Steckanschlüsse für die Baugruppe aufweist und daß in dem Baugruppenträger selbst Steckanschlüsse für die interne Verdrahtung der Baugruppen untereinander vorgesehen sind, wobei beide Steckanschlußgruppen beim Einsetzen der Baugruppen wirksam werden. Um diesen Anschlußblock für die externe Verdrahtung weiter zu vereinfachen ist es vorteilhaft, wenn der Anschlußblock Halterungsrahmen für die mit Anschlußdrähten versehenen Buchsenanschlüsse aufweist und der oder die Halterungsrahmen im Anschlußblock zum Einschieben der im Halterungsrahmen verrastbaren Buchsenanschlüsse schwenkbar gelagert ist. Hierdurch ist es auf einfache Weise möglich, den Anschlußblock mit Crimp-snap-in-Verbindungen zwischen den Anschlußdrähten und den Buchsenanschlüssen auszustatten, so daß interne Verbindungen und Schraubanschlüsse entfallen können. Es ist auch möglich, nur die im Einzelfall erforderliche Anzahl von Buchsenanschlüssen in die Halterungsrahmen einzuführen. Um keinen zusätzlichen Raum beim Baugruppenträger bzw. bei dem Anschlußblock verschenken zu müssen ist es vorteilhaft, wenn die Halterungsrahmen quer zur Einsteckrichtung der Buchsenanschlüsse in die Schwenklage verschiebbar sind. Um sicherzustellen, daß die Buchsenanschlüsse mit dem Halterungsrahmen beim Einsetzen der Baugruppe sich in der richtigen Lage befinden, ist es weiterhin von Vorteil, wenn die Halterungsrahmen in der Betriebsstellung mit dem Anschlußblock verrastet sind. Um ein sicheres Verbinden der Baugruppen mit dem Baugruppenträger und dem Anschlußblock zu ermöglichen ist es weiterhin von Vorteil, wenn an dem Baugruppenträger Schwenkmittel für das Einschwenken der Baugruppen vorgesehen sind. Um auch hier eine Bewegung der über Steckverbindung miteinander verbundenen Teile gegeneinander bei extremen Erschütterungen zu vermeiden und damit gegebenenfalls Kontaktversager auszuschließen ist es von Vorteil, wenn die Schwenkmittel aus einem beim Einschwenken sich in einer Einschubnut im Baugruppenträger verspannenden Exzenterzapfen bestehen. Um eine seitliche Verschiebung der Baugruppenträger auf der Tragschiene in Längsrichtung derselben zu verhindern, jedoch ein Auswechseln der Baugruppenträger auch zwischen zwei benachbarten Baugruppenträgern zu ermöglichen ist es weiterhin von Vorteil, wenn die Baugruppenträger beim Aufschnappvorgang untereinander in Tragschienenlängsrichtung wirksam werdende Verhakungsmittel aufweisen. Der Masseanschluß zwischen Baugruppenträger und Baugruppe läßt sich auf einfache Weise herstellen, wenn die Baugruppenträger eine das Gehäuse des Baugruppenträgers durchdringende, mit der Tragschiene in Berührung bringbare Massekontaktierungsfeder aufweisen. Um zu verhindern, daß Baugruppen an falschen Stellen des Automatisierungsgerätes mit Baugruppenträgern verbunden werden ist es weiterhin von Vorteil, wenn an dem Baugruppenträger eine stufenweise verdrehbare, auf die einzusetzende Baugruppe anpaßbare Codierscheibe angeordnet ist. Hier kann auf der Baugruppe der Hinweis vermerkt werden, in welcher Stellung die Codierscheibe sich befinden muß, so daß bei Installation des Automatisierungsgerätes durch den Fachmann die entsprechende Codierung eingestellt werden kann. Um Spannungsverschleppungen zwischen Baugruppe, Baugruppenträger und Anschlußblock zu vermeiden ist es weiterhin von Vorteil, wenn an dem Baugruppenträger und an dem Anschlußblock Nuten zum Eingreifen von an den Baugruppen angeformten Kragen und Trennwänden vorhanden sind. Um das Automatisierungsgerät mit an einem anderen Ort vorgesehenen Baugruppenträgern erweitern zu können ist es weiterhin von Vorteil, wenn mit dem Baugruppenträger ein auf die Tragschiene aufschnappbarer Verteilerbaustein verbindbar ist.

Anhand der Zeichnung wird ein Ausführungsbeispiel gemäß der Erfindung beschrieben und die Wirkungsweise näher erläutert.

Es zeigen:

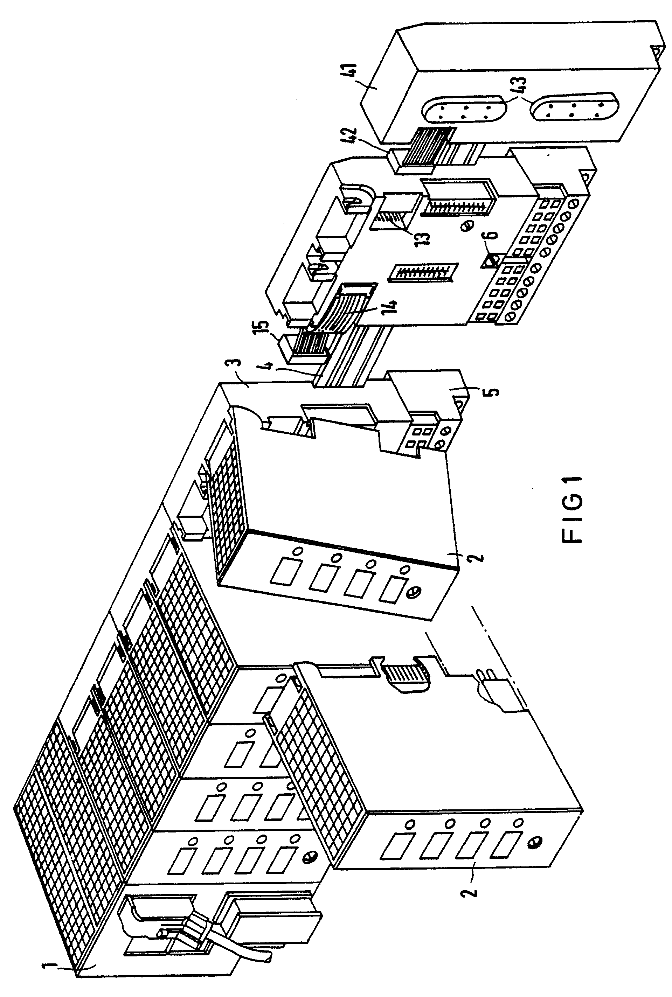

Fig. 1 eine perspektivische Darstellung des Automatisierungsgerätes, zum Teil mit abgenommenen Baugruppen,

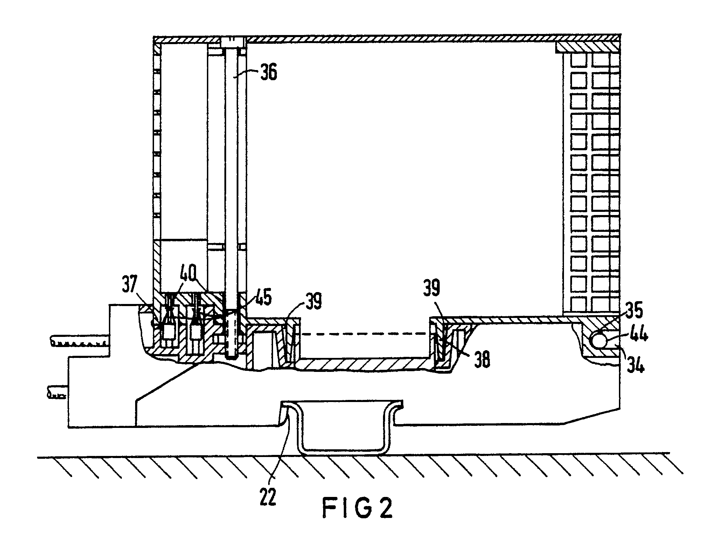

Fig. 2 eine Schnittdarstellung durch eine über den Baugruppenträger und den Anschlußblock mit der Tragschiene verbundene Baugruppe,

Fig. 3 Vorderansicht auf den Baugruppenträger mit angesetztem Anschlußblock,

Fig. 4 den Baugruppenträger nach Fig. 3 mit abgenommenem Deckteil,

Fig. 5 eine Schnittdarstellung gemäß der Linie V - V nach Fig. 4,

Fig. 6 eine Schnittdarstellung durch den Anschlußblock mit Schraubanschluß,

Fig. 7 und 8 Draufsicht und Seitenansicht, zum Teil im Schnitt, durch die Baugruppen-Codierungsscheibe.

Fig. 9 eine Vorderansicht auf den Baugruppenträger mit angesetztem Anschlußblock für Crimp-snap-in-Technik,

Fig. 10 eine Schnittdarstellung durch den Baugruppenträger gemäß Fig. 9 mit ausgeschwenktem Halterahmen und

Fig. 11 eine Schnittdarstellung durch den Anschlußblock und Halterahmen.

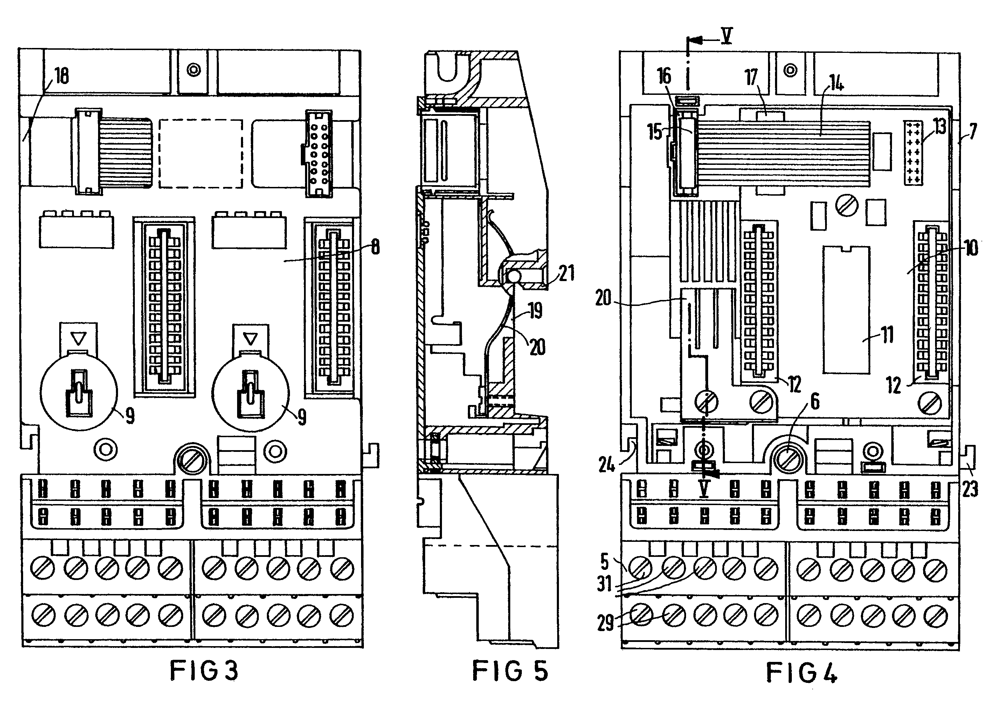

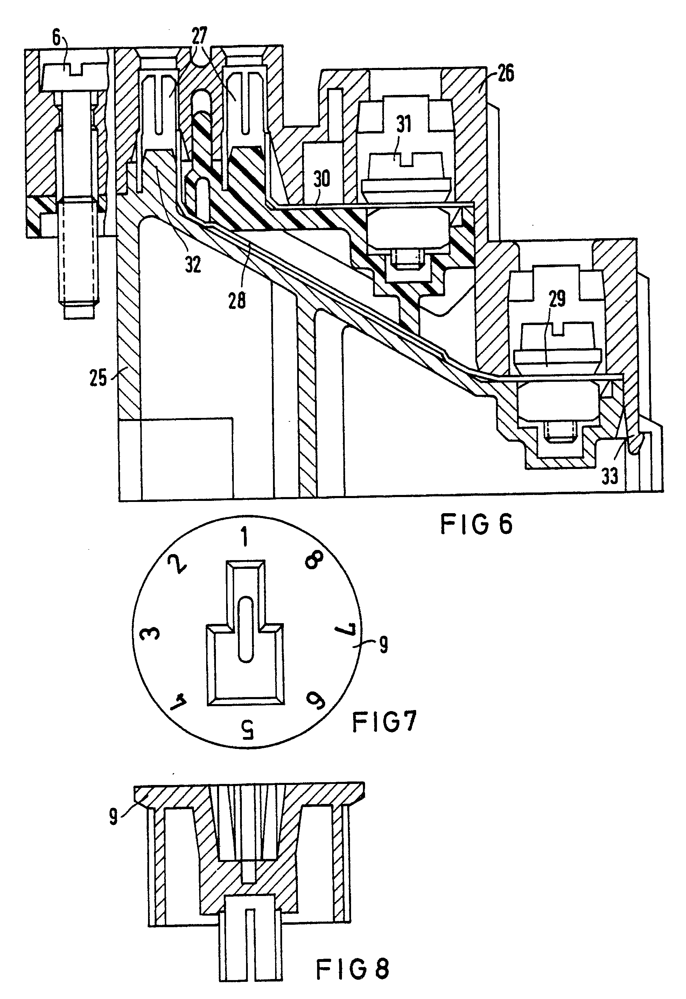

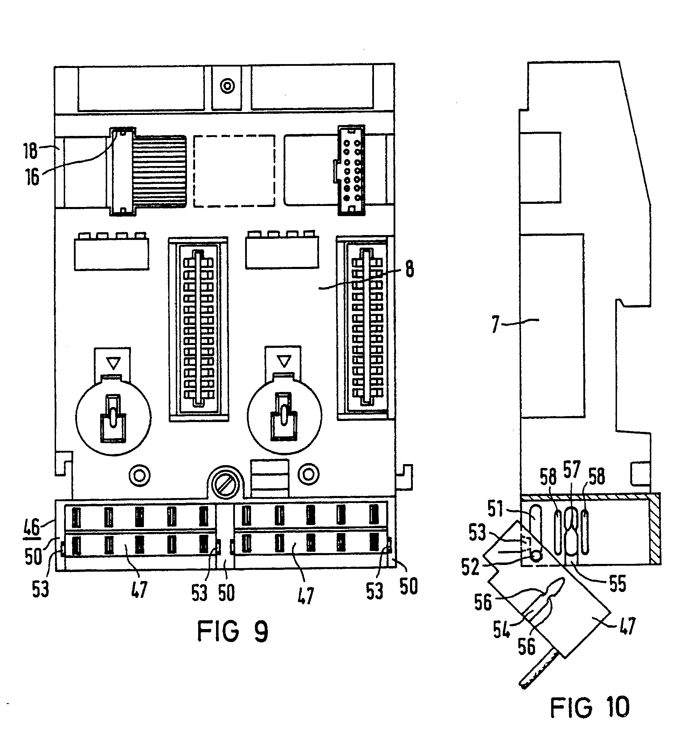

Das in der Zeichnung dargestellte Automatisierungsgerät besteht aus der Zentraleinheit 1 und den Ein- bzw. Ausgabebaugruppen 2, sowie den Baugruppenträgern 3, die auf die Tragschiene 4 aufgeschnappt sind. Mit den Baugruppenträgern 3 sind die Anschlußblöcke 5 für die externe Verdrahtung über eine Schraube 6 miteinander verbunden. Der Baugruppenträger 3 besteht, wie die Fig. 3 bis 5 zeigen, aus dem Unterteil 7 und dem Deckteil 8, an dem die Codierscheiben 9 nach Art einer Codieruhr verdrehbar gehalten sind. Der nähere Aufbau der Codieruhr, die in das Deckteil eingeschnappt sind, ist aus den Fig. 7 und 8 zu ersehen. Ein entsprechender, mit der Codieruhr zusammenwirkender, fest eingestellter Ansatz ist an den Ein- bzw. Ausgabebaugruppen 2 vorgesehen. Mit diesem Baugruppenträger 3 können nach Ausführungsbeispiel zwei Ein- bzw. Ausgabebaugruppen (auch gemischt) verbunden werden. Im Unterteil 7 ist eine Schaltungsplatine 10 befestigt, die die Anpaßschaltung mit dem IC 11 beinhaltet. Auf der Schaltungsplatine 10 sind Buchsenleisten 12 zum Verbinden mit den Steckanschlüssen der Ein- bzw. Ausgabebaugruppen 2 befestigt und elektrisch verbunden. Zum Verbinden der modularen Baugruppenträger 3 untereinander dient eine Steckerleiste 13, die an der Schaltungsplatine elektrisch angeschlossen mit dem Bandkabel 14 in Verbindung steht, an dem seinerseits eine Buchsenleiste 15 angeschlossen ist, die in einer Tasche 16 des Unterteils 7 im nicht angeschlossenen Zustand der Baugruppenträger gehalten ist. Das Bandkabel 14 ist in einer Schlaufe geführt und an der Anschlußleiste 17 an der Schaltungsplatine 10 angeschlossen und kann seitlich durch eine Öffnung 18 im Deckteil 8 herausgeführt werden und mit der Steckerleiste 13 des benachbarten Baugruppenträgers 3 kontaktiert werden. Für die Masseverbindung mit der Tragschiene 4 sorgt eine durch den Durchbruch 19 im Unterteil 7 hindurchragende und mit der Schaltungsplatine 10 verbundene Massekontaktierungsfeder 20. Der Baugruppenträger 3 wird mit den Vorsprüngen 21 an der Tragschiene 4 eingehängt und nach Verschwenken mit dem federbelasteten Riegel 22 an der Tragschiene verrastet. Aus dem Unterteil 7 seitlich hervorstehende Nasen 23 greifen beim Einschwenken der Baugruppenträger auf die Tragschiene in Ausnehmungen 24 des benachbarten Baugruppenträgers 3, so daß sich eine Verhakung der Baugruppenträger 3 untereinander ergibt und ein Verschieben der Baugruppenträger untereinander in Längsrichtung der Tragschiene verhindert wird. Diese Verhakung ist so ausgeführt, daß ein Baugruppenträger zwischen zwei benachbarten Baugruppenträgern ohne Entfernung dieser gewechselt werden kann. Der über die Schraube 6 mit dem Baugruppenträger 3 verbundene Anschlußblock 5 besteht aus dem Unterteil 25 und dem Deckteil 26. Buchsenkontakte 27 zur Verbindung mit den Baugruppen liegen einerseits mit dem Flachleiter 28 und der Anschlußschraube 29 am Unterteil 25 und andererseits mit dem Flachleiter 30 und der Anschlußschraube 31 an einem Isolierzwischenteil 32 auf. Unterteil 25 und Deckteil 26 sind über Schnappverbindung 33 miteinander verbunden und halten so die eingelegten Anschlußelemente. Der Anschlußblock kann je nach Bedarf als Schraubanschluß, Steckanschluß, Crimpanschluß oder in sonstiger bekannter Art und Weise ausgebildet werden. Er kann beim Abnehmen des Baugruppenträgers 3 und Lösen der Befestigungsschraube 6 am Einbauort verbleiben, d.h. die externen Verbindungsleitungen an den Anschlußschrauben 29 und 31 brauchen nicht gelöst zu werden. Zum Einbringen der Baugruppen 2 dienen Drehzapfen 44, die in entsprechende Nuten 34 am Baugruppenträger 3 eingeschoben werden können. Die Nuten 34 enden halbkreisförmig. Die Drehzapfen 44 besitzen eine Exzenteranformung 35, so daß beim Einschwenken der Baugruppen eine Verspannung zwischen Baugruppe und Baugruppenträger erfolgt. Nach Einschwenken wird die Baugruppe am Baugruppenträger 3 über eine Schraube 36 gesichert. An den Baugruppen 2 sind Kragen 37 bzw. Trennwände 38 angeformt, die in entsprechende Nuten 39 am Baugruppenträger bzw. 40 am Anschlußblock hineinragen, um Spannungsverschleppungen zu vermeiden. Um auch Ein- bzw. Ausgabebaugruppen, die an einer anderen Tragschiene befestigt sind, von der Zentraleinheit 1 versorgen zu können, ist ein Verteilerbaustein 41 von Vorteil, der auf die Tragschiene 4 aufgeschnappt ist und über eine Buchsenleiste 42 mit der Steckerleiste 13 des letzten Baugruppenträgers in Verbindung gebracht werden kann. Die Ableitung zu den weiteren, gesondert angeordneten Baugruppenträgern erfolgt über Steckanschlüsse 43. Der über die Schraube 6 mit dem Baugruppenträger 3 verbundene Anschlußblock 5 besteht gemäß der Ausführung nach den Fig. 9 bis 11 aus dem Unterteil 46 mit zwei Halterungsrahmen 47 für die Buchsenanschlüsse 48, die mittels Crimp-snap-in-Verbindung mit den Anschlußdrähten 49 elektrisch leitend verbunden sind. In den Seitenwänden 50 des Unterteils 46 sind nutenförmige Führungsausnehmungen 51 für an den Halterungsrahmen 47 angeformte Schwenkzapfen 52 eingeformt. Das Einführen der Schwenkzapfen 52 in die Führungsausnehmungen 51 erfolgt über Einführungsschlitze 53. An den Seitenwänden der Halterungsrahmen 47 sind Führungsfedern 54 angeformt, die in Führungsnuten 55 an der Innenseite der Seitenwände 50 einführbar sind. Hierzu kommt der Schwenkzapfen 52 an der dem Baugruppenträger 3 abgewandten Seite der Führungsausnehmungen 51 zur Anlage. Der Halterungsrahmen 47 wird derart verschwenkt, daß die Führungsfedern 54 mit den Führungsnuten 55 fluchten, so daß der Halterungsrahmen 47 in Richtung auf den Baugruppenträger 3 verschoben werden kann. An den Führungsfedern 54 sind Ausnehmungen 56 eingeformt, die mit Rastnoppen 57 an den Seitenwänden 50 in der Betriebsstellung der Halterungsrahmen 47 in Eingriff kommen. Die federnde Nachgiebigkeit der Rastnoppen 57 wird durch Aussparungen 58 in den Seitenwänden 50 erreicht.

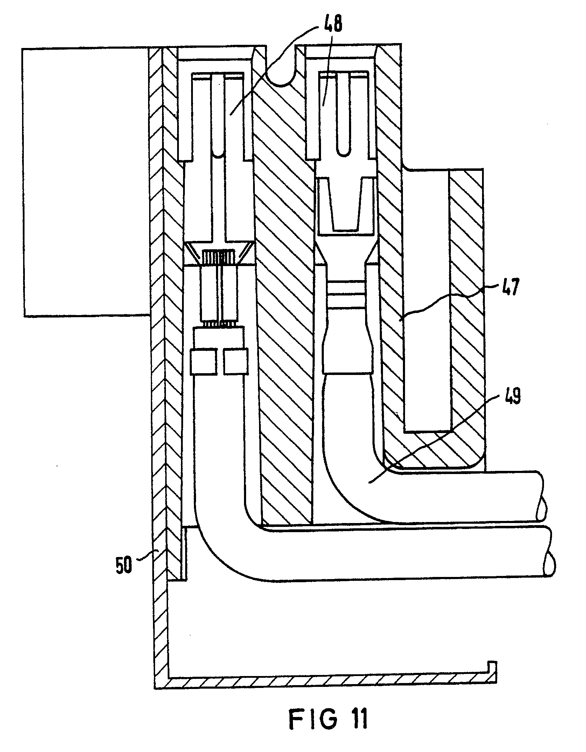

Die Erstellung der externen Verdrahtung der Baugruppenträger 3 ist hier mit der bekannten Crimp-snap-in-Technik auf einfache Weise herstellbar. Der Halterungsrahmen 47 wird aus dem Unterteil 46 herausgeschoben, bis der Schwenkzapfen 52 am Ende der Führungsausnehmung 51 anliegt. Hiernach kann der Haltererungsrahmen 47 in die aus Fig. 3 ersichtliche Lage geschwenkt werden. Die Buchsenanschlüsse werden in die entsprechenden Kanäle im Halterungsrahmen 47 eingeführt und hierin verrastet. Die Anschlußdrähte werden um 90° abgebogen, wie dies aus Fig. 11 ersichtlich ist, und hernach kann der Halterungsrahmen 47 in der zuvor beschriebenen Weise in die Betriebsstellung gebracht werden.

Das erfindungsgemäße Automatisierungsgerät erlaubt es somit, je nach der Anzahl benötigter Ein- bzw. Ausgabebaugruppen das System modular zusammenzufügen, d.h. je nach Bedarf einzelne Baugruppenträger auf die Tragschiene 4 aufzuschnappen und über die Buchsenleiste 15 mit der Steckerleiste 13 des benachbarten Baugruppenträgers zu verbinden, wodurch die Funktionsbereitschaft sichergestellt ist. Es ist hier nicht erforderlich, ungenutzte Baugruppenträger mit der Tragschiene zu verbinden.

## Ansprüche

1. Automatisierungsgerät, bestehend aus auf eine Tragschiene aufschnappbaren Baugruppenträgern, die über Steuerleitungen miteinander verbindbar sind, sowie Anschlußmitteln für externe Verdrahtung zu den Baugruppen, **dadurch gekennzeichnet,** daß die Baugruppenträger (3) einzeln als modulare, eine entsprechende Anpassungsschaltung (10) aufweisende Baugruppenträger (3) ausgebildet sind, die über Steckverbindung (13, 14, 15) mit benachbarten Baugruppenträgern (3) elektrisch verbindbar sind.

2. Gerät nach Anspruch 1, **dadurch gekennzeichnet**, daß der (3) Baugruppenträger jeweils einen Stecker (13) und eine Buchse (15) aufweist, wobei der Stecker (13) starr und die Buchse (15) über eine flexible Leitung (14) mit der in dem Baugruppenträger (3) gehaltenen Anpaßschaltung (10) verbunden sind.

3. Gerät nach Anspruch 2, **dadurch gekennzeichnet**, daß die Buchse (15) in einer Tasche (16) des Baugruppenträgers (3) vor der Verbindung gehalten ist.

4. Gerät nach Anspruch 1, 2 oder 3, **dadurch gekennzeichnet**, daß dem Baugruppenträger (3) ein gesonderter Anschlußblock (5) für die externe Verdrahtung zugeordnet ist, der Buchsenanschlüsse (27) für die Baugruppe (2) aufweist und daß in dem Baugruppenträger (3) selbst Steckanschlüsse für die interne Verdrahtung der Baugruppen (3) untereinander vorgesehen sind, wobei beide Steckanschlußgruppen (27, 12) beim Einsetzen der Baugruppen wirksam werden.

5. Gerät nach Anspruch 4, **dadurch gekennzeichnet**, daß an dem Baugruppenträger (3) Schwenkmittel mittel (44) für das Einschwenken der Baugruppen (3) vorgesehen sind.

6. Gerät nach Anspruch 5, **dadurch gekennzeichnet**, daß die Schwenkmittel aus einem beim Einschwenken sich in einer Einschubnut (34) im Baugruppenträger (3) verspannenden Exzenterzapfen (35) bestehen.

7. Gerät nach einem der vorhergehenden Ansprüche, **dadurch gekennzeichnet**, daß die Baugruppenträger (3) beim Aufschnappvorgang untereinander in Tragschienenlängsrichtung wirksam werdende Verhakungsmittel (23, 24) aufweisen.

8. Gerät nach einem der vorhergehenden Ansprüche, **dadurch gekennzeichnet**, daß die Baugruppenträger (3) eine das Gehäuse des Baugruppenträgers durchdringende, mit der Tragschiene (4) in Berührung bringbare Massekontaktierungsfeder (20) aufweisen.

9. Gerät nach einem der vorhergehenden Ansprüche, **dadurch gekennzeichnet**, daß an dem Baugruppenträger (3) eine stufenweise verdrehbare, auf die einzusetzende Baugruppe (2) anpaßbare Codierscheibe (9) angeordnet ist.

10. Gerät nach einem der vorhergehenden Ansprüche, **dadurch gekennzeichnet**, daß an dem Baugruppenträger (3) und an dem Anschlußblock (5) Nuten (39, 40) zum Eingreifen von an den Baugruppen angeformten Kragen (37) und Trennwänden (38) vorhanden sind.

11. Gerät nach einem der vorhergehenden Ansprüche, **dadurch gekennzeichnet**, daß mit dem Baugruppenträger ein auf die Tragschiene (4) aufschnappbarer Verteilerbaustein (41) verbindbar ist.

12. Gerät nach Anspruch 4, **dadurch gekennzeichnet**, daß der Anschlußblock (5) Halterungsrahmen (47) für die mit Anschlußdrähten (49) versehenen Buchsenanschlüsse (48) aufweist und der oder die Halterungsrahmen (47) im Anschlußblock (5) zum Einschieben der im Halterungsrahmen (47) verrastbaren Buchsenanschlüsse (48) schwenkbar gelagert ist.

13. Gerät nach Anspruch 12, **dadurch gekennzeichnet**, daß die Halterungsrahmen (47) quer zur Einsteckrichtung der Buchsenanschlüsse (48) in die Schwenklage verschiebbar sind.

14. Gerät nach Anspruch 12 oder 13, **dadurch gekennzeichnet**, daß die Halterungsrahmen (47) in der Betriebsstellung mit dem Anschlußblock (5) verrastet sind.

**Claims**

1. Automation assembly comprising module supports which can be snapped on to a supporting rail, which module supports can be connected to one another by means of control lines, as well as connection means for external wiring to the modules, characterized in that the module supports (3) are constructed individually as modular module supports (3) having a corresponding adaptation circuit (10), which module supports can be electrically connected by means of plug-in connection (13, 14, 15) to adjacent module supports (3).

2. Assembly according to claim 1, characterized in that the module support (3) has in each case a plug (13) and a socket (15), wherein the plug (13) is connected rigidly to the adaptation circuit (10), held in the module support (3), and the socket (15) is connected by means of a flexible line (14).

3. Assembly according to claim 2, characterized in that the socket (15) is held in a recess (16) of the module support (3) in before the connection.

4. Assembly according to claim 1, 2 or 3, characterized in that with the module support (3) there is associated a separate terminal block (5) for external wiring, which terminal block has sockets (27) for the module (2), and in that in the module support (3) itself there are provided plug-in connections for the internal wiring of the modules (3) to one another, whereby both plug-in connection units (27, 12) become operative with the insertion of the modules.

5. Assembly according to claim 4, characterized in that pivot means (44) for tilting the modules (3) are provided on the module support (3).

6. Assembly according to claim 5, characterized in that the tilting means consist of an eccentric lug (35) which is tensioned in an insertion groove (34) in the module support (3) when tilting takes place.

7. Assembly according to one of the preceding claims, characterized in that the module supports (3) have interlocking means (23, 24) which, during the snapping-on process with one another, become operative in the supporting rail longitudinal direction.

8. Assembly according to one of the preceding claims, characterized in that the module supports (3) have an earth contacting spring (20) which penetrates the housing of the module support and which can be brought into contact with the supporting rail (4).

9. Assembly according to one of the preceding claims, characterized in that on the module support (3) there is arranged a coding disc (9) which can be rotated in stages and which can be adapted to the module (2) to be inserted.

10. Assembly according to one of the preceding claims, characterized in that on the module support (3) and on the terminal block (5) grooves (39, 40) are present for engaging collars (37), moulded on the modules, and partitions (38).

11. Assembly according to one of the preceding claims, characterized in that a distributor module (41), which can be snapped on to the supporting rail (4), can be connected to the module support.

12. Assembly according to claim 4, characterized in that the terminal block (5) has mounting frames (47) for the sockets (48) provided with connection wires (49), and the holding frame or frames (47) is/are rotatably mounted in the terminal block (5) for the insertion of the sockets (48) which can be latched in the holding frame (47).

13. Assembly according to claim 12, characterized in that the holding frames (47) can be displaced into the tilting position at right angles to the plug-in direction of the sockets (48).

14. Assembly according to claim 12 or 13, characterized in that in the operational position the holding frames (47) are latched to the terminal block (5).

## Revendications

1. Appareil d'automatisation, constitué par des porte-modules, pouvant être fixés par encliquetage brusque sur un rail de support et raccordés entre eux au moyen de lignes de commande, ainsi que des moyens de raccordement d'un câblage externe aux modules, caractérisé par le fait que les porte-modules (3) sont réalisés individuellement sous la force de porte-modules modulaires (3), qui comportent un circuit d'adaptation correspondant (10) et peuvent être raccordés électriquement au moyen de connecteurs (13,14,15) à des porte-modules (3) voisins.

2. Appareil suivant la revendication 1, caractérisé en ce que les porte-modules (3) comportent chacun une prise mâle (13) et une prise femelle (15), la prise mâle (13) étant raccordée rigidement et la prise femelle (15) par l'intermédiaire d'un conducteur flexible (14) au circuit d'adaptation (10) maintenu dans le porte-modules (3).

3. Appareil suivant la revendication 2, caractérisé par le fait que la prise femelle (15) est retenue dans une cavité (16) du porte-modules (3), avant le raccordement.

4. Appareil suivant la revendication 1, 2 ou 3, caractérisé par le fait qu'au porte-modules (3) est associé un bloc particulier de raccordement (5) pour le câblage externe, qui comporte des bornes en forme de prises femelles (27) pour le module (2) et que des bornes formant prises mâles pour le câblage interne des modules (3) entre eux sont prévues dans le porte-modules (3) lui-même, les deux groupes (27,12) de bornes formant prises mâles devenant actifs lors de l'utilisation des modules.

5. Appareil suivant la revendication 4, caractérisé par le fait que sur le porte-modules (3) il est prévu des moyens de pivotement (44) permettant l'introduction par pivotement des modules (3).

6. Appareil suivant la revendication 5, caractérisé par le fait que les moyens de pivotement sont constitués par un téton excentré (35) qui pénètre dans une rainure d'insertion (34) ménagée dans le porte-modules.

7. Appareil suivant l'une des revendications précédentes, caractérisé par le fait que les porte-modules (3) possèdent des moyens d'accrochage (23,24) qui, lors de l'opération d'encliquetage brusque, deviennent actifs entre eux dans la direction longitudinale du rail de support.

8. Appareil suivant l'une des revendications précédentes, caractérisé par le fait que les porte-modules (3) possèdent un ressort (20) d'établissement d'un contact avec la masse, qui traverse le boîtier du porte-modules et peut être placé en contact avec le rail de support (4).

9. Appareil suivant l'une des revendications précédentes, caractérisé par le fait qu'un disque de codage (9) pouvant tourner pas-à-pas et pouvant être adapté au module (2) devant être utilisé, est disposé sur le porte-modules (3).

10. Dispositif suivant l'une des revendications précédentes, caractérisé par le fait que des rainures (39,40) permettant l'engrènement de collets (37) et de parois de séparation (38), formés par moulage sur les modules, sont ménagées dans le porte-modules (3) et sur le bloc de raccordement (5).

11. Appareil suivant l'une des revendications précédentes, caractérisé par le fait qu'un module de distribution (41) pouvant être fixé par encliquetage brusque sur le rail de support (4), peut être raccordé au porte-modules.

12. Appareil suivant la revendication 1, caractérisé par le fait que le bloc de raccordement (5) comporte des cadres de support (47) pour les bornes en forme de prises femelles (48) équipées de fils de raccordement (49) et que le ou les cadres de support (47) sont montés pivotants dans le bloc de raccordement (5) de manière à permettre l'insertion des bornes en forme de prises femelles (48) pouvant être verrouillées dans le cadre de support (47).

13. Appareil suivant la revendication 12, caractérisé par le fait que les cadres de support (47) peuvent être amenés dans la position pivotée par déplacement transversal par rapport à la direction d'enfichage des bornes en forme de prises femelles (48).

14. Appareil suivant la revendication 12 ou 13, caractérisé par le fait que les cadres de support (47) sont encliquetés sur le bloc de raccordement (5) dans la position de service.

FIG1

EP 0 236 711 B1

FIG 2

FIG 3

FIG 5

FIG 4

EP 0 236 711 B1

FIG 6

FIG7

FIG 8

FIG 9

FIG 10

FIG 11